# EUROPÄISCHE PATENTSCHRIFT

(11) **EP 1 066 209 B1**
(45) Veröffentlichungstag und Bekanntmachung des Hinweises auf die Patenterteilung: **28.05.2003**
(21) Anmeldenummer: 99916879.2
(22) Anmeldetag: 23.03.1999
(51) Int. Cl.: B65G 49/02, C25D 17/00

(54) **VORRICHTUNG ZUR BEHANDLUNG VON PLATTENFÖRMIGEN WERKSTÜCKEN, INSBESONDERE LEITERPLATTEN**
DEVICE FOR TREATING PLATE-SHAPED WORK PIECES, ESPECIALLY PRINTED-CIRCUIT BOARDS
DISPOSITIF POUR TRAITER DES PIECES EN FORME DE PLAQUETTE, NOTAMMENT DES CARTES DE CIRCUITS INTEGRES

(30) Priorität: 26.03.1998 DE 19813528
(43) Veröffentlichungstag der Anmeldung: 10.01.2001
(73) Patentinhaber: Siemens S.A., 1060 Bruxelles (BE)
(72) Erfinder: DENYS, Wilfried, B-8020 Oostkamp (BE)
(74) Vertreter: Berg, Peter, Dipl.-Ing.
(86) Internationale Anmeldenummer: EP9901984
(87) Internationale Veröffentlichungsnummer: WO99048780

(56) Entgegenhaltungen:
- EP-A- 0 289 195
- DE-C- 324 473

## Beschreibung

Aus der EP-A-0 421 127 ist eine Vorrichtung zur Behandlung von Leiterplatten bekannt, bei welcher die einzelnen Leiterplatten in senkrecht hängender Lage auf einem horizontalen Transportweg kontinuierlich durch nacheinander angeordnete Behandlungsbäder geführt werden. Der Transport der Leiterplatten durch die in Behandlungszellen untergebrachten Behandlungsbäder erfolgt über an endlos umlaufenden Trieben angeordnete Klammern, die im Falle einer galvanischen Behandlung gleichzeitig auch die kathodische Kontaktierung der Leiterplatten übernehmen. In den Stirnwänden der Behandlungszellen befinden sich vertikale Schlitze für den Durchtritt der Leiterplatten, wobei im Durchtrittsbereich als Bürstendichtungen oder Streifenbürstendichtungen ausgebildete Dichtungen vorgesehen sind. Die einzelnen Behandlungszellen sind in Auffangwannen angeordnet, aus welchen die aufgefangene Badflüssigkeit mit Hilfe entsprechender Pumpen kontinuierlich in die zugeordneten Behandlungszellen zurückgeführt wird. Auch hier wird durch die kontinuierliche Rückführung der Badflüssigkeit die Aufrechterhaltung eines konstanten Pegelstandes in den einzelnen Behandlungszellen ermöglicht.

Aus der US-A-4 401 522 ist eine ähnlich aufgebaute Vorrichtung zur elektrolytischen Behandlung von Leiterplatten bekannt, bei welcher den vertikalen Schlitzen in den Stirnwänden der Behandlungszellen als Dichtungen vertikal angeordnete Walzenpaare zugeordnet sind. Die aus einem elastischen Material bestehenden Walzen dieser Walzenpaare werden federnd gegeneinandergedrückt und mit einer auf die Transportgeschwindigkeit der durchlaufenden Leiterplatten abgestimmten Drehzahl angetrieben.

Bei einer weiteren, aus der EP-B-0 760 023 bekannten Vorrichtung zur Behandlung von plattenförmigen Werkstücken, insbesondere Leiterplatten, sind den vertikalen Schlitzen als Dichtungen paarweise, in vertikaler Ausrichtung lose im Behandiungsbad angeordnete Stäbe oder Rohre zugeordnet. Durch ihre lose Anordnung im Behandlungsbad werden diese Stäbe oder Rohre durch den Flüssigkeitsdruck gegeneinander oder gegen das jeweils durchlaufende Werkstück und gegen die zugeordnete Stirnwand der Behandlungszelle gedrückt. Die Abdichtung der vertikalen Schlitze wird hier also praktisch selbsttätig durch den Druck der Badflüssigkeit bewirkt.

Das vorstehend geschilderte Abdichtungsprinzip mit lose im Behandlungsbad angeordneten Dichtungen hat sich bei der Behandlung von Werkstücken bzw. Leiterplatten mit Plattendicken von mehr als 0,25 mm hervorragend bewährt. Bei Werkstücken mit Plattendicken bis zu 0,25 mm, insbesondere bei dünnen nicht starren Leiterplatten, kommt es jedoch einlaufseitig beim Eintritt in die Behandlungszelle zu Verformungen der Werkstücke. Diese Verformungen sind auf den hohen Flüssigkeitsdruck im unteren Bereich der Behandlungszellen zurückzuführen, durch welchen die Dichtungen im unteren Bereich stärker gegeneinander gedrückt werden und den Eintritt der Werkstücke in die Behandlungszelle erschweren.

Aus der EP-A-0 289 195 ist eine Vorrichtung zur Behandlung von plattenförmigen Werkstücken, insbesondere Leiterplatten, in einer Vakuumkammer bekannt, bei welcher die Werkstücke kontinuierlich in vertikaler Lage auf einem horizontalen Transportweg über eine erste Dichtung, eine erste Schleusenkammer und eine zweite Dichtung in die Vakuumkammer transportiert werden und die Vakuumkammer dann über eine dritte Dichtung, eine zweite Schleusenkammer und eine vierte Dichtung wieder verlassen. Innerhalb der Vakuumkammer werden die Werkstücke beispielsweise durch Sputtern, Plasmaätzen, Bedampfen oder CVD-Abscheidung behandelt. Die erste und die vierte Dichtung bestehen jeweils aus zwei Rohren oder Stäben, die in Ausnehmungen zu beiden Seiten des Transportweges derart angeordnet sind , dass sie an den durchlaufenden Werkstücken anliegen. Die vertikal ausgerichteten Dichtungen sind dabei jeweils in einer Kopfplatte und einer Bodenplatte drehbar gelagert, wobei die vertikale Führung der Werkstücke durch eine aus der Bodenplatte herausragende untere Führungsschiene und eine federnd in der Kopfplatte gelagerte obere Führungsschiene erfolgt. Für den Transport der Werkstücke ist ein einlaufseitig mit Abstand zu der ersten Dichtung angeordnetes Walzenpaar vorgesehen, welches jeweils ein Werkstück in einen vertikalen Schlitz des Stützgehäuses für die erste Dichtung einschiebt und damit sämtliche aneinander anliegenden Werkstücke durch die Vorrichtung durchschiebt.

Der im Anspruch 1 angegebenen Erfindung liegt das Problem zugrunde, bei der aus der EP-B-0 760 023 bekannten Vorrichtung zur Behandlung von plattenförmigen Werkstücken das Abdichtsystem so zu ertüchtigen, dass auch eine Behandlung von dünnen Werkstücken ermöglicht wird.

Der Erfindung liegt die Erkenntnis zugrunde, dass durch ein einlaufseitig unmittelbar vor den Dichtungen angeordnetes Walzenpaar eine Führung und Versteifung dünner Werkstücke bewirkt wird, die dann einen problemlosen Einlauf in die Dichtungen und in das Behandlungsbad ermöglicht. Hervorzuheben ist dabei, dass durch die Kombinationen von lose im Behandlungsbad angeordneten Dichtungen und Führungswalzen sowohl dünne als auch dicke Werkstücke behandelt werden können.

Vorteilhafte Ausgestaltungen der Erfindung sind in den Unteransprüchen angegeben.

Die Ausgestaltung nach Anspruch 2 ermöglicht im Bedarfsfall einen sicheren Auslauf dünner Werkstücke aus dem Behandlungsbad. Ein Verbiegen dünner Werkstücke beim Auslauf aus dem Behandlungsbad ist jedoch nur in Ausnahmefällen zu befürchten, da hier der Flüssigkeitsdruck auf die Werkstücke dem Druck auf die Dichtungen entspricht.

Die Weiterbildung nach Anspruch 3 erleichtert den Eintritt der Werkstücke in ein Walzenpaar in erheblichem Maße. Somit können noch dünnere Werkstücke behandelt werden, als dies bei nicht angetriebenen Walzen der Fall ist.

Die Ausgestaltung nach Anspruch 4 ermöglicht mit minimalem Aufwand einen Antrieb der Walzen. Außerdem ist bei einem Antrieb der Walzen durch die Transportmittel stets eine Abstimmung der Walzendrehzahl auf die Transportgeschwindigkeit der durchlaufenden Werkstücke gewährleistet. Gemäß Anspruch 5 wird dabei ein reibschlüssiger Antrieb der Walzen durch die Transportmittel bevorzugt, da er äußerst robust ist und mit geringem Aufwand realisiert werden kann.

Die Weiterbildung nach Anspruch 6 ermöglicht durch die federnde Aufstellung einer Walze eine selbsttätige Anpassung der Walzenführung an die Dicke der jeweils zu behandelnden Werkstücke.

Ein Ausführungsbeispiel der Erfindung ist in der Zeichnung dargestellt und wird im folgenden näher beschrieben.
Es zeigen
Figur 1 eine Draufsicht auf den Einlaufbereich einer Behandlungszelle mit einem vor der Schleusenkammer angeordneten Führungswalzenpaar,
Figur 2 eine Draufsicht auf die gesamte Behandlungszelle gemäß Figur 1 mit einem auslaufseitig innerhalb des Behandlungsbades vor der Schleusenkammer angeordneten zweiten Führungswalzenpaar und
Figur 3 eine Seitenansicht eines Führungswalzenpaares.

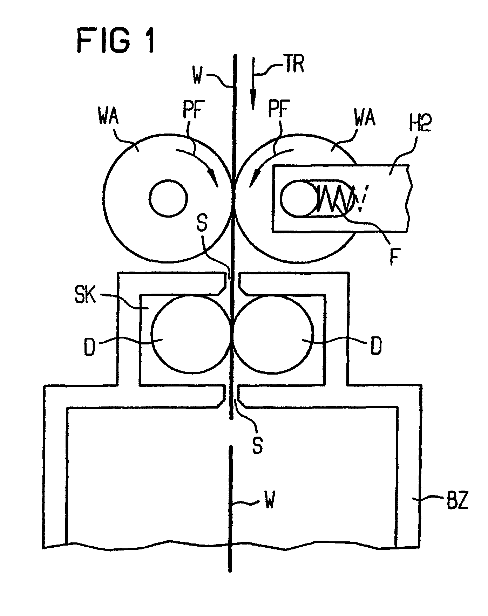

Figur 1 zeigt eine Draufsicht auf den Einlaufbereich einer ein Behandlungsbad enthaltenden Behandlungszelle BZ, durch welche an hier nicht dargestellten klammerförmigen Transportmitteln senkrecht hängende, plattenförmige Werkstücke W hindurchgeführt werden. An der einlaufseitigen Stirnseite der Behandlungszelle BZ befindet sich eine Schleusenkammer SK, in welcher zwei durch kreiszylindrische Kunststoffrohre gebildete Dichtungen D in vertikaler Ausrichtung lose angeordnet sind. Die Stirnwände der Behandlungszelle BZ und der Schleusenkammer SK sind mit vertikalen Schlitzen S versehen, durch welche die plattenförmigen Werkstücke W unbehindert hindurchgeführt werden können.

Der Flüssigkeitsdruck des in der Behandlungszelle BZ und in der Schleusenkammer SK vorhandenen Behandlungsbades wirkt auf etwa drei Viertel des Umfanges der Dichtungen D ein, während auf das restliche Viertel von außen der normale Atmosphärendruck einwirkt. Die resultierenden auf die Dichtungen D wirkenden Kräfte drücken die Dichtungen D dann einerseits gegen das durchlaufende Werkstück W und anderserseits gegen die Stirnwand der Schleusenkammer SK. Damit ergibt sich eine wirkungsvolle Abdichtung, die den Austritt von Badflüssigkeit durch den äußeren vertikalen Schlitz S zumindest weitgehend verhindert. Befindet sich zwischen den beiden Dichtungen D gerade kein Werkstück W, so werden sie gegeneinander gedrückt und verhindern damit ebenfalls einen Austritt von Badflüssigkeit.

Durch den hohen Flüssigkeitsdruck im unteren Bereich der Behandlungszelle BZ werden die beiden Dichtungen D dort auch stärker gegeneinander oder gegen ein durchlaufendes Werkstück W gedrückt, als dies im oberen Bereich der Fall ist. Bei Werkstücken W mit Plattendicken bis zu 0,25 mm, insbesondere bei dünnen, nicht starren Leiterplatten, kommt es dadurch einlaufseitig beim Eintritt in die Schleusenkammer SK zu Verformungen der Werkstücke W. Um diese Verformungen zu verhindern, sind unmittelbar vor der Schleusenkammer SK zwei vertikal ausgerichtete Walzen WA zur Führung der Werkstücke W angeordnet. Diese beiden in Richtung der Pfeile PF angetriebenen Walzen WA erfassen die in Transportrichtung TR einlaufenden Werkstücke W und führen sie durch den vertikalen Schlitz S der Schleusenkammer SK den darin angeordneten Dichtungen D zu. Da die beiden Walzen WA eine vertikale Versteifung der Werkstücke W bewirken und unmittelbar vor der Schleusenkammer SK angeordnet sind, kann auch bei sehr dünnen Werkstücken W die Gefahr einer Verbiegung beim Eintritt in die Dichtungen D ausgeschlossen werden.

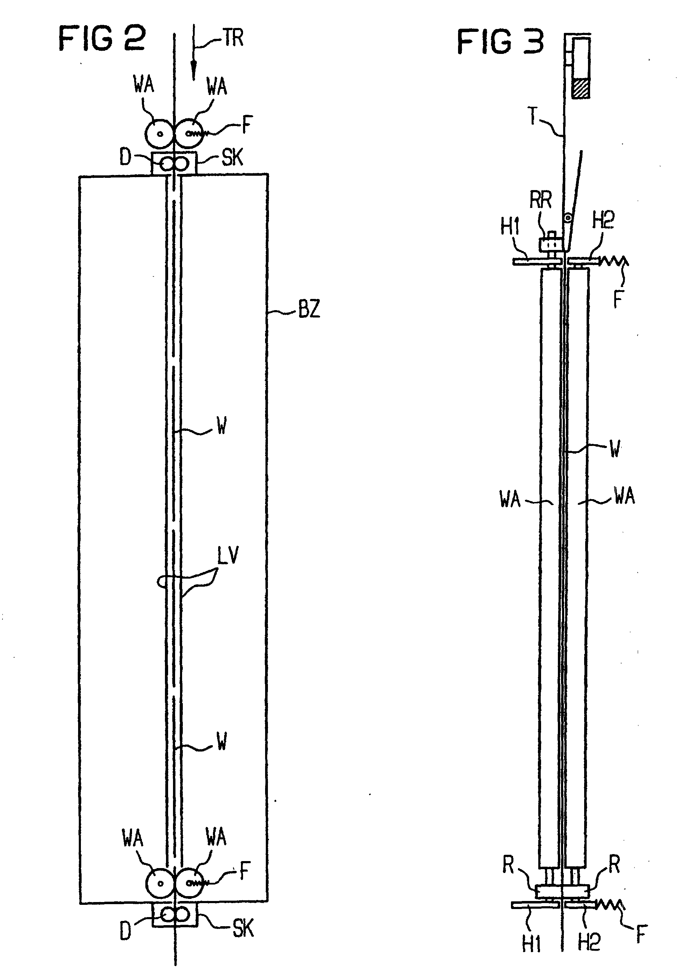

Wie insbesondere in Figur 3 zu erkennen ist, ist eine der beiden Walzen WA in einer Halterung H1 fest angeordnet, während die andere in einer Halterung H2 angeordnete Walze WA über Federn F gegen die erste Walze WA gedrückt ist. Durch diese federnde Anordnung der beiden Walzen WA wird eine selbsttätige Anpassung der Walzenführung an unterschiedliche Dicken der jeweils einlaufenden Werkstücke W ermöglicht.

Figur 3 zeigt ferner die im Zusammenhang mit Figur 1 bereits erwähnten klammerförmigen Transportmittel T, an welchen die plattenförmigen Werkstücke W senkrecht hängend durch die Behandlungszelle BZ hindurchgeführt werden. Von diesen klammerförmigen Transportmitteln T wird die fest angeordnete Walze WA über ein oberes Reibrad RR angetrieben. Der Antrieb der federnd angeordneten Walze WA erfolgt dann über zwei Räder R, die jeweils am unteren Ende einer Walze WA angeordnet sind und im dargestellten Ausführungsbeispiel ebenfalls reibflüssig ineinandergreifen.

Figur 2 zeigt eine Draufsicht auf die in Figur 1 nur einlaufseitig dargestellte Behandlungszelle BZ. Es ist erkennbar, daß auslaufseitig ebenfalls eine Schleusenkammer SK mit zwei darin enthaltenen Dichtungen D vorgesehen ist. Im Gegensatz zum Einlaufbereich sind die beiden auslaufseitigen Walzen WA jedoch in Transportrichtung TR gesehen innerhalb der Behandlungszelle BZ unmittelbar vor der Schleusenkammer SK angeordnet.

Figur 2 zeigt außerdem eine sich innerhalb der Behandlungszelle BZ in Transportrichtung TR erstreckende Leitvorrichtung LV. Aufgabe dieser Leitvorrichtung LV ist es, dünne Werkstükke W, wie z.B. nicht starre Leiterplatten, insbesondere in ihrem unteren Bereich gezielt zu führen. Durch das Zusammenwirken dieser Leitvorrichtung LV mit den beiden einlaufseitig und im dargestellten Ausführungsbeispiel auch auslaufseitig angeordneten Walzenführungen ergibt sich auch bei sehr dünnen Werkstücken eine sichere Führung durch die gesamte Behandlungszelle BZ.

## Patentansprüche

1. Vorrichtung zur Behandlung von plattenförmigen Werkstücken (W), insbesondere Leiterplatten, mit
- Transportmitteln (T), welche die Werkstücke (W) in vertikaler Lage auf einem horizontalen Transportweg durch mindestens ein Behandlungsbad führen,
- einer Behandlungszelle (BZ) zur Aufnahme des' Behandlungsbades,
- vertikalen Schlitzen (S) in den Stirnwänden der Behandlungszelle (BZ) für den Durchtritt der Werkstücke (W), und mit
- den vertikalen Schlitzen (S) zugeordneten Dichtungen (D), die durch paarweise, in vertikaler Ausrichtung lose im Behandlungsbad angeordnete Stäbe oder Rohre gebildet sind, **gekennzeichnet durch**
- ein einziges einlaufseitig außerhalb der Behandlungszelle (BZ) in Transportrichtung unmittelbar vor den Dichtungen (D) angeordnetes, vertikal ausgerichtetes Paar von Walzen (WA) zur Führung der Werkstücke (W) und
- ein einziges weiteres, auslaufseitig innerhalb der Behandlungszelie (BZ) in Transportrichtung unmittelbar vor den Dichtungen (D) angeordnetes, vertikal ausgerichtetes Paar von Walzen (WA) zur Führung der Werkstücke (W).

2. Vorrichtung nach Anspruch 1,
**dadurch gekennzeichnet ,**
**daß** die Walzen (WA) angetrieben sind.

3. Vorrichtung nach Anspruch 2,
**dadurch gekennzeichnet ,**
**daß** die Walzen (WA) durch die Transportmittel (T) der Werkstücke (W) angetrieben sind.

4. Vorrichtung nach Anspruch 2,
**dadurch gekennzeichnet ,**
**daß** die Walzen (WA) reibschlüssig durch die Transportmittel (T) der Werkstücke (W) angetrieben sind.

5. Vorrichtung nach einem der Ansprüche 1 bis 4,
**dadurch gekennzeichnet ,**
**daß** eine Walze (WA) federnd gegen die benachbarte Walze (WA) oder gegen das jeweils durchlaufende Werkstück (W) gedrückt ist.

## Claims

1. Device for treating plate-shaped work pieces (W), in particular printed circuit boards, having
- conveying means (T) which guide the work pieces (W) in a vertical position through at least one treatment bath on a horizontal conveying path,
- a treatment cell (BZ) for holding the treatment bath,
- vertical slots (S) in the end walls of the treatment cell (BZ) for the work pieces (W) to pass through, and having
- seals (D) which are assigned to the vertical slots (S) and are formed by rods or tubes arranged loosely in vertically oriented pairs in the treatment bath,
**characterized by**
- a single vertically oriented pair of rolls (WA), arranged on the inlet side outside the treatment cell (BZ), immediately in front of the seals (D) in the conveying direction, for guiding the work pieces (W), and
- a single further vertically oriented pair of rolls (WA) arranged on the outlet side inside the treatment cell (BZ), immediately in front of the seals (D) in the conveying direction, for guiding the work pieces (W).

2. Device according to Claim 1, **characterized in that** the rolls (WA) are driven.

3. Device according to Claim 2, **characterized in that** the rolls (WA) are driven by the conveying means (T) for the work pieces (W).

4. Device according to Claim 2, **characterized in that** the rolls (WA) are frictionally driven by the conveying means (T) for the work pieces (W).

5. Device according to one of Claims 1 to 4, **characterized in that** one roll (WA) is pressed resiliently onto the adjacent roll (WA) or onto the work piece (W) which is passing between them at the time.

## Revendications

1. Dispositif pour le traitement de pièces en forme de plaque (W), en particulier des cartes de circuits imprimés, comprenant:
- des moyens de transport (T) qui guident les pièces (W) en position verticale à travers au moins un bain de traitement et sur un parcours de transport horizontal,
- une cellule de traitement (BZ) pour recevoir le bain de traitement,
- des fentes verticales (S) ménagées dans les parois frontales de la cellule de traitement (BZ) pour permettre le passage des pièces (W), et
- des joints d'étanchéité (D) associés aux fentes verticales (S) et formés par des barreaux ou tubes orientés à la verticale, disposés par paires et lâchement dans le bain de traitement,
**caractérisé par**:
- une paire unique de cylindres (WA) pour le guidage des pièces (W), orientée à la verticale et disposée du côté de l'entrée à l'extérieur de la cellule de traitement (BZ), immédiatement en amont des joints d'étanchéité (D) dans la direction du transport et
- une autre paire unique de cylindres (WA) pour le guidage des pièces (W), orientée à la verticale et disposée du côté de la sortie à l'intérieur de la cellule de traitement (BZ), immédiatement en amont des joints d'étanchéité (D) dans la direction du transport.

2. Dispositif selon la revendication 1, **caractérisé en ce que** les cylindres (WA) sont entraînés.

3. Dispositif selon la revendication 2, **caractérisé en ce que** les cylindres (WA) sont entraînés par les moyens de transport (T) des pièces (W).

4. Dispositif selon la revendication 2, **caractérisé en ce que** les cylindres (WA) sont entraînés par frottement par les moyens de transport (T) des pièces (W).

5. Dispositif selon l'une des revendications 1 à 4, **caractérisé en ce qu'**un cylindre (WA) est repoussé élastiquement contre le cylindre (WA) voisin ou contre la pièce (W) respective pendant sa traversée.
